**Europäisches Patentamt**

**European Patent Office**

**Office européen des brevets**

(11) Publication number : **0 401 495 B1**

## (12) EUROPEAN PATENT SPECIFICATION

(45) Date of publication of patent specification :
**26.10.94 Bulletin 94/43**

(21) Application number : **90107183.7**

(22) Date of filing : **14.04.90**

(51) Int. Cl.⁵ : **H05K 7/20, B01D 53/26**

(51) Int. Cl.⁵ : $H05K\ 7/20$, $B01D\ 53/26$

---

(54) **Enclosure for controllers.**

---

(30) Priority : **07.06.89 JP 146040/89**

(43) Date of publication of application :
**12.12.90 Bulletin 90/50**

(45) Publication of the grant of the patent :
**26.10.94 Bulletin 94/43**

(84) Designated Contracting States :
**CH DE GB LI**

(56) References cited :
**EP-A- 0 313 658**
**ELEKTROTECHNIK, vol. 68, no. 11, June 1986,**
**pages 34-39, Würzburg, DE; "Wichtig:**
**richtiges Klima; Schaltschrankheiz- und**
**Kühlgeräte"**

(73) Proprietor : **MITSUBISHI DENKI KABUSHIKI**
**KAISHA**
**2-3, Marunouchi 2-chome**
**Chiyoda-ku**
**Tokyo 100 (JP)**

(72) Inventor : **Yamauchi, Takao, c/o Mitsubishi**
**Denki K.K.**
**Itami Works,**
**1-1, Tsukaguchi Honmachi 8 chome**
**Amagasaki-shi, Hyogo (JP)**

(74) Representative : **Eisenführ, Speiser & Partner**
**Martinistrasse 24**
**D-28195 Bremen (DE)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

#### Field of the Invention

This invention relates to a humidity-controlled enclosure for holding electrical controllers in an outdoor, or similar environment having a greatly varying degree of humidity.

#### Description of the Prior Art

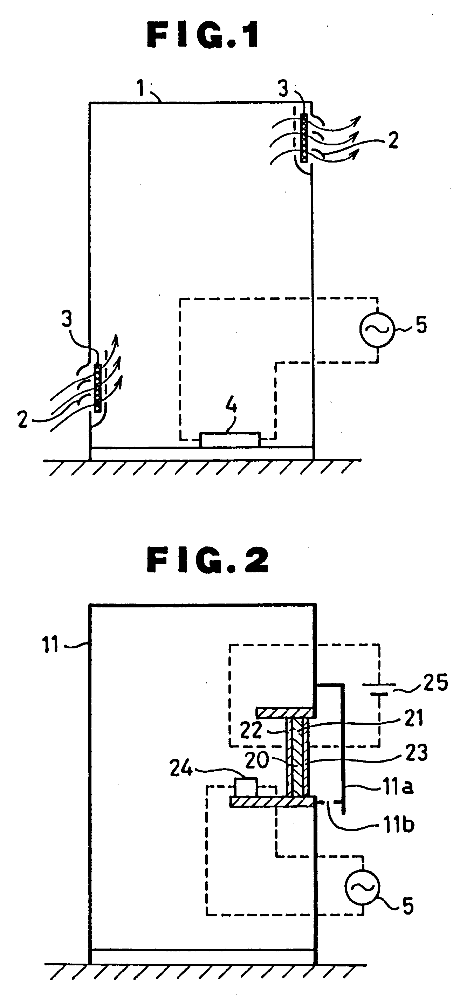

Reference is made to FIGURE 1 showing a known enclosure for holding controllers for electric power switches. It comprises a casing 1 having two ventilating openings 2 each provided with an air filter 3. An electric heater 4 is provided for heating air in the casing 1 and an AC power source 5 is connected to the heater 4. The casing 1 is ventilated, as air flows into and out of the casing 1 in the directions of arrows through its ventilating openings 2, so that the same level of humidity may be maintained in the casing 1 as in its surroundings. It is, however, likely that a sudden change in temperature which may occur from e.g. a rainfall may cause the formation of dew on the inner wall surface of the casing 1 if the casing 1 is not effectively ventilated. The heater 4 is, therefore, provided for heating air in the casing 1 to a level which is at least several degrees higher than the temperature of the ambient air and thereby lowering the relative humidity of the air in the casing 1. This heating, however, requires the heater 4 to have a considerably large capacity and means, therefore, a considerably large consumption of electrical energy. Nevertheless, it is only possible to lower the relative humidity of the air in the casing 1 to a level which is still considerably high.

From EP-A-0313658 there is further known an enclosure according to the prior art portion of claim 1.

### SUMMARY OF THE INVENTION

It is an object of this invention to provide an enclosure for electrical controllers which can maintain a satisfactorily low level of humidity without calling for a large consumption of energy.

It is a further object of this invention to provide an enclosure which can effectively prevent any undesirable temperature elevation from occurring in the first casing in which an electrical apparatus is located, even if it may be exposed to sunlight.

These objects are essentially attained by an enclosure for an electrical controller comprising: a first casing having an opening in its wall; a humidity control device provided in said first casing adjacent to said opening so as to close said opening, said device comprising a hydrogen ion conductor composed of a solid electrolyte, a first electrode in the form of a porous film joined to one of two opposite surfaces of said hydrogen ion conductor and a second electrode in the form of a porous film joined to the other of said surfaces, said second electrode facing said opening, while said first electrode faces the interior of said first casing; and means for applying a DC voltage between said first and second electrodes characterized by a second casing, having at least one ventilating opening, for covering at least an outer surface of said humidity control device.

The air in the enclosure of this invention can efficiently be maintained at a satisfactorily low level of humidity.

These and other objects, features and advantages of this invention will become more apparent from the following description and the accompanying drawings.

### BRIEF DESCRIPTION OF THE DRAWINGS

FIGURE 1 is a schematic elevational and sectional view of the known enclosure;
FIGURE 2 is a similar view of an enclosure shown for explanatory reasons;
FIGURE 3 is a similar view of an enclosure shown for explanatory reasons;
FIGURE 4 is a similar view showing an enclosure embodying this invention; and
FIGURE 5 is a similar view showing a further embodiment.

### DETAILED DESCRIPTION OF THE PREFERRED EMBODIMENTS

The invention will now be described more specifically with reference to the drawings. It is, however, to be understood that the drawings and the following description are not intended for limiting the scope of this invention as claimed.

Referring first to FIGURE 2, there is shown an enclosure for explanatory reasons. It comprises a casing 11 having an opening in its wall, a cover 11a provided for substantially closing the opening, but having a ventilating opening 11b, a humidity control device 20 positioned in the casing 11 adjacent to its wall opening in such a way as to close it, a heater 24 provided in the casing 11 for heating the humidity control device 20, and a DC power source 25 which is electrically connected to the humidity control device 20. The humidity control device 20 comprises a hydrogen ion conductor 21 composed of a solid electrolyte, a first electrode 22 in the form of a porous film bonded to one of two opposite sides of the hydrogen ion conductor 21, and a second electrode 23 in the form of a porous film bonded to the other of the opposite sides of the hydrogen ion conductor 21. The power source 25 is electrically connected between the first and second electrodes 22 and 23. The electrodes 22 and 23 are so positioned that the first electrode 22 is in contact with the air in the casing 11, while the second electrode 23 is exposed to the air in its surroundings.

In operation, the first electrode 22 is used as an anode, and the second electrode 23 as a cathode, and a DC voltage is applied across the humidity control device 20. As a result, the following electrode reaction takes place in the interfacial layer between the first electrode 22 and the hydrogen ion conductor 21:

$$H_2O \rightarrow 2H^+ + \frac{1}{2}O_2 + 2e^-$$

In other words, the water which the air in the casing 11 contains is electrolyzed. The hydrogen ions move toward the second electrode 23, or cathode, while the oxygen molecules remain in the casing 11, and their electric charges move to the first electrode 22, or anode. When the hydrogen ions have reached the interfacial layer between the hydrogen ion conductor 21 and the second electrode 23, at least one of the following electrode reactions takes place:

$$2H^+ + \frac{1}{2}O_2 + 2e^- \rightarrow H_2O$$
$$2H^+ + 2e^- \rightarrow H_2$$

The humidity control device 20 is heated by the heater 24 located near it and connected electrically to the AC power source 5, so that the elevated temperature of the hydrogen ion conductor 21 raises its ion conductivity. The electrode reactions expel water from the air in the casing 11 effectively and thereby maintain a satisfactorily low level of humidity in the casing 11. The higher the temperature of the hydrogen ion conductor 21, the more rapidly the electrode reactions proceed.

Although the heater 24 connected to the AC power source is shown in FIGURE 2 for heating the humidity control device 20, it is also possible to employ any other appropriate means, such as an infrared lamp, or a thin film resistor, for heating it.

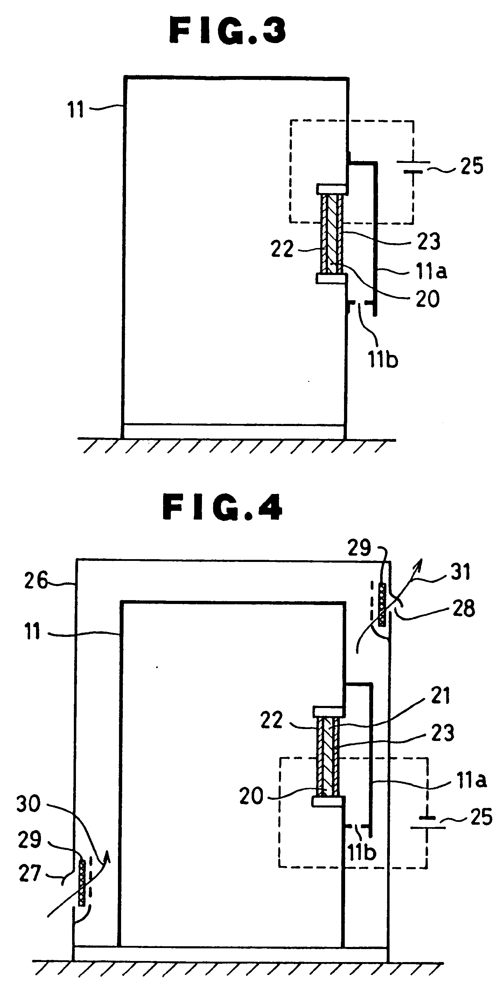

A modified form of enclosure is shown in FIGURE 3 for explanatory reasons. It does not include any such heater as is shown at 24 in FIGURE 2. This enclosure is, however, expected to produce similar results of humidity control, as the humidity control device 20 is exposed through the opening 11b of the cover 11a to the ambient air which effectively promotes the electrode reactions if it is moist enough.

Referring again to the enclosure of FIGURE 2, the cover 11a, the humidity control device 20 and the heater 24 can be so constructed as to form a unitary assembly which is removable from the casing 11. This construction facilitates their inspection, and maintenance, including the change of any part thereof.

An enclosure embodying this invention is shown in FIGURE 4. It comprises a first casing 11, which corresponds to the casing 11 shown in FIGURE 3, and a second casing 26 surrounding the first casing 11. The second casing 26 has two ventilating openings 27 and 28, and an air filter 29 provided adjacent to each of the openings 27 and 28. Arrows 30 and 31 show the directions in which air can flow through the second casing 26. In any other respect, the enclosure is substantially identical in construction to that of FIGURE 3. As the electrode reactions proceed, water moves from the first casing 11 to the second casing 26, and a stream of air flowing through the second casing 26 in the directions of the arrows 30 and 31 carries the water out of the second casing 26. Moreover, the double-walled construction of the enclosure shown in FIGURE 4 can effectively prevent any undesirable temperature elevation from occurring in the first casing 11 in which an electrical apparatus is located, even if it may be exposed to sunlight.

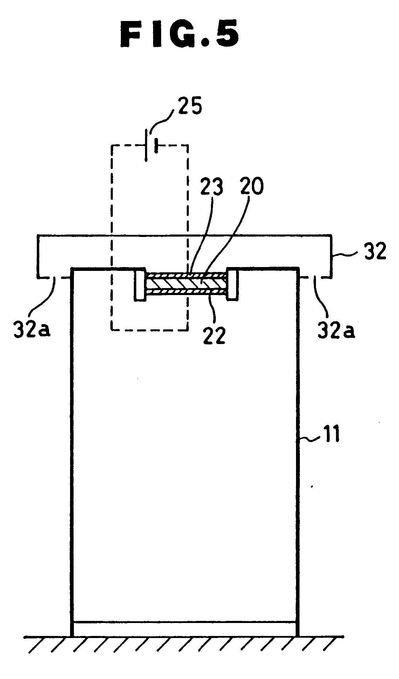

A modified form of the two-casing enclosure is shown in FIGURE 5. It comprises a first casing 11, and a second casing 32 having ventilating openings 32a and positioned on the top of the first casing 11. The humidity control device 20 is positioned at the top of the first casing 11. The construction shown in FIGURE 5 can effectively reduce any temperature elevation that sunlight may bring about in the casing 11.

## Claims

1. An enclosure for an electrical controller comprising:
   a first casing (11) having an opening in its wall;
   a humidity control device (20) provided in said first casing (11) adjacent to said opening so as to close said opening, said device (20) comprising a hydrogen ion conductor (21) composed of a solid electrolyte, a first electrode (22) in the form of a porous film joined to one of two opposite surfaces of said hydrogen ion conductor (21) and a second electrode (23) in the form of a porous film joined to the other of said surfaces, said second electrode (23) facing said opening, while said first electrode (22) faces the interior of said first casing (11); and
   means (25) for applying a DC voltage between said first and second electrodes (22, 23);
   characterized by
   a second casing (26; 32), having at least one ventilating opening (27; 28; 32a), for covering at least an outer surface of said humidity control device (20).

2. An enclosure as set forth in claim 1, further comprising: means (24), provided in said first casing (11), for heating said humidity control device (20).

3. An enclosure as set forth in claim 1 or 2, further comprising: a cover (11a), having a ventilating opening (116), for covering an outer surface of said humidity control device (20).

**4.** An enclosure as set forth in claim 3, wherein said humidity control device (20) and said cover (11a) form a unitary assembly which is removable from said first casing (11).

**5.** An enclosure as set forth in claim 3, wherein said humidity control device (20), said heating means (24) and said cover (11a) form a unitary assembly which is removable from said first casing (11).

**Patentansprüche**

**1.** Ein Gehäuse für einen elektronischen Regler mit einem ersten Gehäuse (11), das eine Öffnung in seiner Wandung aufweist, einer Feuchtigkeits-Regeleinrichtung (20), die in dem ersten Gehäuse (11) an der Öffnung angrenzend untergebracht ist, um die Öffnung zu verschließen, und die Einrichtung (20) aufweist einen Wasserstoffionenleiter (21), zusammengesetzt aus einem Trockenelektrolyt, eine erste Elektrode (22) in Form eines porösen Films, der mit einer von zwei entgegengesetzten Flächen des Wasserstoffionenleiters (21) verbunden ist und eine zweite Elektrode (23) in Form eines porösen Films, die mit der anderen der Flächen verbunden ist, die zweite Elektrode (23) die Öffnung abschirmt, während die erste Elektrode (22) das Innere des ersten Gehäuses (11) abschirmt, und Mittel (25) zum Anlegen einer Gleichspannung zwischen der ersten und zweiten Elektrode (22, 23) **gekennzeichnet durch** ein zweites Gehäuse (26; 32), das wenigstens eine Ventilationsöffnung (27; 28; 32a) aufweist, um wenigstens eine äußere Fläche der Feuchtigkeits-Regeleinrichtung (20) abzudekken.

**2.** Ein Gehäuse nach Anspruch 1, das ferner Mittel (24) enthält, die zur Erwärmung der Feuchtigkeits-Regeleinrichtung (20) in dem ersten Gehäuse (11) ausgebildet sind.

**3.** Ein Gehäuse nach Anspruch 1 oder 2, das ferner eine Abdeckung (11a) mit einer Ventilationsöffnung (116) aufweist, um eine äußere Fläche der Feuchtigkeits-Regeleinrichtung (20) abzudecken.

**4.** Ein Gehäuse nach Anspruch 3, bei der die Feuchtigkeits-Regeleinrichtung (20) und die Abdeckung (11a) einen einheitlichen Aufbau bilden, der von dem ersten Gehäuse (11) abnehmbar ist.

**5.** Ein Gehäuse nach Anspruch 3, bei dem die Feuchtigkeits-Regeleinrichtung (20), die Wärmemittel (24) und die Abdeckung (11a) einen einheitlichen Aufbau bilden, welcher von dem ersten Gehäuse (11) abnehmbar ist.

**Revendications**

**1.** Enveloppe pour un régulateur électrique comprenant:
un premier boîtier (11) comportant une ouverture dans sa paroi;
un dispositif de contrôle d'humidité (20) prévu dans ledit premier boîtier (11) adjacent à ladite ouverture de manière à fermer ladite ouverture, ledit dispositif (20) comprenant un conducteur à ions hydrogène (21) composé d'un électrolyte solide, une première électrode (22), sous forme d'un film poreux, assemblée à l'une des deux surfaces opposées dudit conducteur à ions hydrogène (21) et une deuxième électrode (23), sous forme d'un film poreux, assemblée à l'autre desdites surfaces, ladite deuxième électrode (23) étant placée face à ladite ouverture, tandis que ladite première électrode (22) est placée face à l'intérieur dudit premier boîtier (11); et
des moyens (25) pour appliquer une tension de courant continu entre lesdites première et deuxième électrodes (22, 23);
caractérisée par
un deuxième boîtier (26; 32) comportant au moins une ouverture de ventilation (27; 28; 32a), pour recouvrir au moins une surface extérieure dudit dispositif de contrôle d'humidité (20).

**2.** Enveloppe selon la revendication 1, comprenant en outre: des moyens (24) prévus dans ledit premier boîtier (11) pour chauffer ledit dispositif de contrôle d'humidité (20).

**3.** Enveloppe selon la revendication 1 ou 2, comprenant en outre: un couvercle (11a), comportant une ouverture de ventilation (116) pour recouvrir une surface extérieure dudit dispositif de contrôle d'humidité (20).

**4.** Enveloppe selon la revendication 3, dans laquelle ledit dispositif de contrôle d'humidité (20) et ledit couvercle (11a) forment un ensemble unitaire qui peut être retiré dudit premier boîtier (11).

**5.** Enveloppe selon la revendication 3, dans laquelle ledit dispositif de contrôle d'humidité (20), ledit moyen de chauffage (24) et ledit couvercle (11a) forment un ensemble unitaire qui peut être retiré dudit premier boîtier (11).

EP 0 401 495 B1

# F I G. 1

# F I G. 2

5

# FIG.3

# FIG.4

# FIG.5